# EUROPÄISCHE PATENTSCHRIFT

(11) **EP 0 353 660 B1**
(45) Veröffentlichungstag und Bekanntmachung des Hinweises auf die Patenterteilung: **10.01.1996**
(21) Anmeldenummer: 89114004.8
(22) Anmeldetag: 28.07.1989
(51) Int. Cl.: G06F 11/16, G06F 11/10

(54) **Verfahren zur Fehlersicherung in Speichersystemen von Datenverarbeitungsanlagen, insbesondere Fernsprechvermittlungsanlagen**
Fault prevention method in memory systems of data-processing installations, in particular telephone exchanges
Procédé de protection contre les fautes dans les systèmes à mémoires d'installation de traitement de données, en particulier les installations de centraux téléphoniques

(30) Priorität: 02.08.1988 DE 3826248
(43) Veröffentlichungstag der Anmeldung: 07.02.1990
(73) Patentinhaber: SIEMENS AKTIENGESELLSCHAFT, D-80333 München (DE)
(72) Erfinder: Knefel, Hans-Werner, Dipl.-Ing., D-8033 Martinsried (DE); Trainer, Carl, Dipl.-Ing., D-8031 Gilching (DE)

(56) Entgegenhaltungen:
- EP-A- 0 080 354
- EP-A- 0 127 118

## Beschreibung

Die Erfindung betrifft ein Verfahren zur Fehlererkennung in Speichersystemen von Datenverarbeitungsanlagen, insbesondere Fernsprechvermittlungsanlagen zur Speicherung von fehlergesicherten Daten mit zumindest in den zentralen Teilen gedoppelter Speichersteuerung, der sämtliche ankommenden Signale zugeführt werden.

Bei Speichersystemen der vorausgesetzten Art sollen nicht nur Informationsverfälschungen erkannt und gegebenenfalls korrigiert werden, die durch Fehlfunktionen des eigentlichen Informationsspeichers verursacht werden (Mediumfehler) sondern auch solche Fehler, die durch Defekte in der Steuerung zustande kommen.

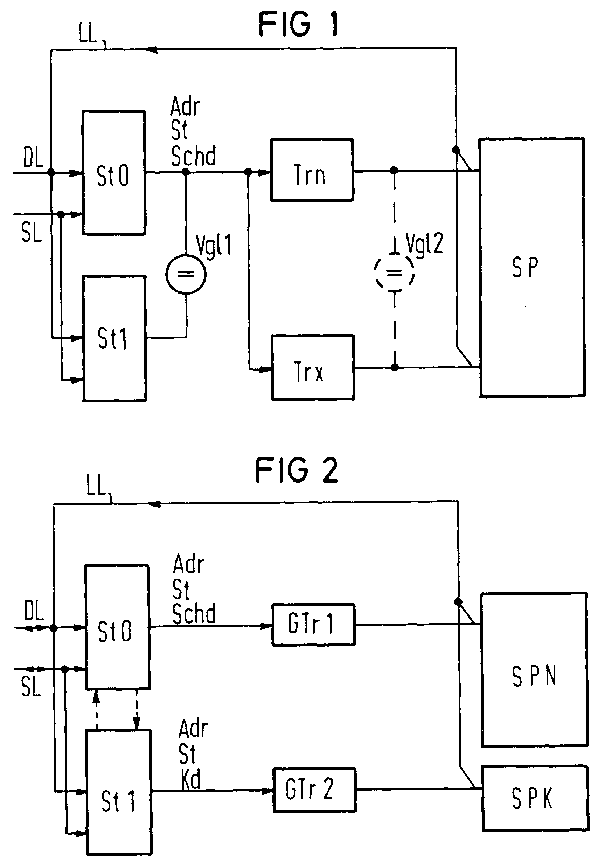

Die Figur 1 zeigt zur Veranschaulichung der zu diesem Zweck bisher ergriffenen Maßnahmen in Blockbildform ein Speichersystem, auf das sich das erfindungsgemäße Verfahren bezieht. Bei diesem bekannten Speichersystem sind zumindest die zentralen Teile der Speichersteuerung St0 und St1 gedoppelt. Es werden diesen Speichersteuerungsteilen sämtliche ankommenden Signale, nämlich die auf einer Datenleitung DL ankommenden Schreibdaten und die auf einer Signalleitung SL ankommenden Adressensignale und Steuersignale zugeführt werden. Die Steuerungsteile St0 und St1 enthalten auch Einrichtungen zur Durchführung einer Datenprüfung und Datenkorrektur. Sofern die der Datensicherung dienenden Kontrollbits nicht schon vor der Datenübertragung gebildet worden und demnach im ankommenden Datenstrom enthalten sind, erfolgt die erstmalige Kontrollbitbildung ebenfalls hier.

Die erwähnten Kontrollbits, die zusammen mit den zugehörigen Datenbits übertragen bzw. in den Speicher SP eingeschrieben werden, entstehen durch Teilparitätsbildungen bei den Datenwörtern. Die Datenüberprüfung wird dann in der Weise durchgeführt, daß nach dem Auslesen der Datenwörter und der zugehörigen Kontrollbits erneut die entsprechenden Teilparitätsbildungen vorgenommen werden und die dabei entstehenden Kontrollbits mit den ursprünglichen Kontrollbits verglichen werden. Im Fehlerfall kann aus den Mustern der Nichtübereinstimmung der durch die Kontrollbits gebildeten Kontrollbitworte im Falle von Einfachfehlern das gestörte Datenbit ermittelt und dementsprechend korrigiert werden. Im Falle von Mehrfachfehlern ist eine Fehleranzeige möglich.

Bei dem Speichersystem gemäß Figur 1 werden die Schreibdaten, die Adressen und die Steuersignale, die sowohl von dem ersten als auch dem zweiten Teil der Speichersteuerung St0 und St1 abgegeben werden, mit Hilfe eines Vergleichers Vgll verglichen, so daß fehlerhafte Ausgangssignale erkannt werden können. Lediglich die von dem Steuerungsteil St0 abgegebenen Signale werden an den Speicher SP weitergeleitet und zwar über Treiber, die um die benötigte Ansteuerleistung für die Speicherblöcke des Speichers SP zu erzielen, vielfach vorgesehen und vorzugsweise paarweise angeordnet sind. Von dieser Treibervielzahl ist in der Figur das Treiberpaar Trn und Trx dargestellt. Die von diesen Treiberpaaren abgegebenen Ausgangssignale werden mit Hilfe von Treibervergleichern Vg12 verglichen, von denen der zu dem genannten Treiberpaar Trn und Trx gehörende Vergleicher Vg12 dargestellt ist. Es sind somit die Treiber überwacht sowie, sofern diese Vergleicher Vg12 am Ende der Leitungsverbindungen zwischen Treiberausgang und Speichereingang angeordnet sind, auch diese Verbindungsleitungen. Der Speicher SP ist zweckmäßigerweise so organisiert, daß er aus gesondert ansteuerbaren Teileinheiten besteht, die lediglich ein Bit eines Speicherworts speichern, so daß durch Mediumfehler bevorzugt Einfachfehler entstehen, die durch die vorerwähnte Datenüberprüfung erkannt und korrigiert werden können.

Die Vergleicher Vgl1 und Vg12 sind vor allem deswegen erforderlich, weil Adreßdefekte, die zum Beschreiben oder Auslesen eines falschen Speicherwortes führen können, durch die Daten überprüfung ausgelesener Speicherworte auf der Basis der vorerwähnten Datensicherungsmaßnahmen nicht zu erkennen sind.

Das vorstehend geschilderte Fehlererkennungskonzept ist zwar sehr wirksam, der Aufwand für die Vergleicher und deren Routineprüfung ist jedoch sehr aufwendig. Außerdem sind die erforderlichen Vergleichsprozeduren oftmals nur auf Kosten längerer Speicherzykluszeiten möglich.

Die Aufgabe der Erfindung besteht darin, ein demgegenüber einfacheres Fehlererkennungskonzept anzugeben.

Erfindungsgemäß wird diese Aufgabe durch Anspruch 1 gelöst, nämlich dadurch daß die eigentlichen Nutzdaten vom ersten der gedoppelten Speichersteuerungsteile und die ihnen zugeordnete mit der Datensicherung im Zusammenhang stehenden Kontrollbits vom zweiten der gedoppelten Speichersteuerungsteile aus in getrennte, taktsynchron betriebene Speicher für Nutzdaten bzw. für Kontrolldaten eingeschrieben werden, von denen aus sie beim Auslesen gemeinsam in die Datenüberprüfung einbezogen werden.

Gegenüber dem bekannten Speichersystem gemäß Figur 1 wird beim erfindungsgemäßen Verfahren also auf die Vergleicher Vgl1 und die Vergleichervielzahl Vg12 verzichtet und dennoch ein gleich guter Fehlererkennungsgrad erreicht. Aufgrund der erfindungsgemäß vorgenommenen Speicherorganisation wird mit hoher Wahrscheinlichkeit auch im Falle eines Adreßfehlers entweder nur der Speicher für Nutzdaten oder der Speicher für Kontrolldaten betroffen sein, so daß bei einer Datenüberprüfung im Zusammenhang mit dem Auslesen, bei der sowohl die Nutzdaten als auch die Kontrolldaten einbezogen sind, ein Fehler erkannt wird. Selbst wenn Mehrfachfehler zunächst nicht erkannt werden oder fälschlicherweise als korrigierbare Einfachfehler erscheinen, wird aufgrund der hohen Adreßvariation bei den Speicherzyklen es sehr schnell zu einer echten Mehrbitfehlererkennung kommen. Gemäß einer weiteren Ausgestaltung der Erfindung werden die vom zweiten Speichersteuerungsteil aus in den betreffenden gesonderten Speicher einzuschreibenden Kontrolldaten vor ihrer Ausgabe mit den entsprechenden im ersten Speichersteuerungsteil zur Verfügung stehenden Kontrolldaten verglichen.

Es ist hiermit erreicht, daß in den Fällen, in denen es nur im zweiten Speichersteuerungsteil zu einer Verfälschung von Nutzdaten kommt und dementsprechend die zugehörigen Kontrolldaten nicht mehr den unverfälschten und vom ersten Speichersteuerungsteil aus tatsächlich in den Nutzdatenspeicher eingespeicherten Nutzdaten entsprechen oder wenn die Kontrolldatenbildung im zweiten Speichersteuerungsteil gestört ist, die Datenüberprüfung beim beim Auslesen nicht fälschlicherweise zu einer Daten-"Korrektur" führt, die in diesem Falle tatsächlich eine Datenverfälschung wäre.

Wenn gemäß einer Ausführungsform der Erfindung der genannte Vergleich in Form eines Paritätsvergleichs durchgeführt wird, ist bei immer noch ausreichend hohem Erkennungsgrad der Aufwand relativ gering.

Nachstehend wird unter Bezugnahme auf eine Zeichnung die Erfindung näher erläutert.

In der Zeichnung zeigen: Figur 1 das schon erläuterte Speichersystem des Standes der Technik.

Figur 2 ein Speichersystem, das im Hinblick auf die Durchführung des erfindungsgemäßen Verfahrens konzipiert ist.

Die Figur 2 zeigt wieder genauso wie Figur 1 eine gedoppelte Speichersteuerung mit den Speichersteuerungsteilen St0 und Stl, die auch Einrichtungen zur Datenüberprüfung bzw. Datenkorrektur enthalten. Für die Durchführung des erfindungsgemäßen Verfahrens ist es ohne Belang, ob die auf den Datenleitungen DL ankommenden Nutzdaten schon sendeseitig mit entsprechenden Kontrolldaten versehen worden sind, oder ob diese Kontrolldaten erst in den Einrichtungen St0 und St1 gebildet werden.

Es werden jedenfalls, wie durch die strichlierten Verbindungspfeile der beiden Steuerungsteile angedeutet, die dort zur Verfügung stehenden einander entsprechenden Kontrolldaten einem Paritätsvergleich unterzogen, womit bei einer Übereinstimmung mit hoher Wahrscheinlichkeit sichergestellt ist, daß die zugehörigen Nutzdaten ebenfalls einander entsprechen. Dies ist besonders dann von Bedeutung, wenn ein Einschreiben neuer Nutzdaten in der Weise erfolgt, daß ausgelesene Nutzdaten partiell, beispielsweise nur in einem von mehreren ein Speicherwort bildenden Bytes geändert werden und dementsprechend eine Neubildung der Kontrolldaten erforderlich ist.

Wie die Figur 2 ferner zeigt, werden durch den einen Steuerungsteil St0 von den hier zur Verfügung stehenden Daten Adressensignale Adr, Steuersignale St und Schreibdaten Schd weitergegeben, nicht jedoch die zu den Schreibdaten gehörigen Kontrolldaten und zwar über eine erste Gruppe von Treibern GTr1. Der andere Steuerungsteil Stl gibt hingegen neben den Adressensignalen Adr und Steuersignalen St die zu den Schreibdaten Schd gehöriger Kontrolldaten Kd, nicht jedoch die Schreibdaten selbst über ein zweite Gruppe von Treibern GTr2 ab.

Die Figur 2 zeigt ferner, daß der Datenspeicher in einen Nutzdatenspeicher SPN und in einen Kontrolidatenspeicher SPK unterteilt ist. Diese Speicher werden im einen Fall über die Treibergruppe GTr1 und im anderen Fall über die Treibergruppe GTr2 erreicht.

Die Aufteilung des Speichers hat zur Folge, daß ein Ansteuerdefekt, der entweder durch eine fehlerhafte Adressenbildung in den zentalen Steuerungsteilen St0 und St1 oder aber durch einen Defekt der betreffenden Treiber zustande kommen kann, mit hoher Wahrscheinlichkeit nur den Speicher SPN oder den Speicher SPK betrifft.

Die beiden genannten Speicher SPN und SPK werden taktsynchron betrieben und liefern beim Auslesen zusammengehörige Nutzdaten und Kontrolldaten über die Leitung LL an die zu den gedoppelten Speichersteuerungen St0 und St1 gehörigen Einrichtungen zur Datenüberprüfung und Datenkorrektur. Eine dort vorgenommene Datenüberprüfung geschieht, wie angedeutet, in der Weise, daß für die ausgelesenen Nutzdaten erneut nach den vorgegebenen Bildungsgesetzen Kontrolldaten gebildet werden und daß diese Kontrolldaten mit den aus dem Speicher ausgelesenen Kontrolldaten verglichen werden.

Im Falle eines Adreßfehlers, der, wie dargelegt, entweder nur den Nutzdatenspeicher oder nur den Kontrolldatenspeicher betrifft, wird daher bei einer solchen Datenüberprüfung mit hoher Wahrscheinlichkeit ein Fehler festgestellt werden.

## Patentansprüche

1. Verfahren zur Fehlererkennung in Speichersystemen von Datenverarbeitungsanlagen, insbesondere Fernsprechvermittlungsanlagen, zur Speicherung von fehlergesicherten Daten mit zumindest in den zentralen Teilen gedoppelter Speichersteuerung, der sämtliche ankommenden Signale zugeführt werden,
**dadurch gekennzeichnet,**
daß vom ersten der gedoppelten Speichersteuerungsteile (St0) neben den Adress- und Steuersignalen (Adr, St) lediglich die eigentlichen Nutzdaten (Schd) und vom zweiten der gedoppelten Speichersteuerungsteile (St1) neben den erwähnten Adress- und Steuersignalen lediglich die den Nutzdaten im Zusammenhang mit der Datensicherung zugeordneten Kontrolldaten (Kd) weitergegeben werden und daß die Nutzdaten und Kontrolldaten jeweils unter derselben Adresse in getrennte, taktsynchron betriebene Speicher für Nutzdaten (SPN) und Kontrolldaten (SPK) eingeschrieben werden, von wo aus sie beim Auslesen gemeinsam in die Datenüberprüfung einbezogen werden.

2. Verfahren nach Anspruch 1,
**dadurch gekennzeichnet,**
daß die vom zweiten Speichersteuerungsteil (ST1) aus in den betreffenden gesonderten Speicher (SPK) einzuschreibenden Kontrolldaten (KD) für ihrer Ausgabe mit den entsprechenden im ersten Speichersteuerungsteil (St0) zur Verfügung stehenden Kontrolldaten verglichen werden.

3. Verfahren nach Anspruch 2,
**dadurch gekennzeichnet,**
daß der genannte Vergleich ein Paritätsvergleich ist.

## Claims

1. Method for error detection in memory systems of data processing installations, in particular telephone exchanges, for storing error-protected data with dual memory control at least in the central parts, to which all incoming signals are supplied, characterized in that, in addition to the address and control signals (Adr, St), only the actual payload data (Schd) are forwarded by the first of the dual memory control parts (St0), and, in addition to the aforesaid address and control signals, only the control data (Kd) assigned to the payload data in connection with the data protection are forwarded by the second of the dual memory control parts (St1), and in that the payload data and control data are written in each case to the same address in separate, clock-synchronous stores for payload data (SPN) and control data (SPK), from where they are both included in the data checking when the data are read out.

2. Method according to Claim 1, characterized in that, for their output, the control data (KD) to be written by the second memory control part (ST1) into the respective separate store (SPK) are compared with the corresponding control data available in the first memory control part (St0).

3. Method according to Claim 2, characterized in that the said comparison is a parity comparison.

## Revendications

1. Procédé de reconnaissance d'erreurs de systèmes de mémoire d'installations de traitement de données, notamment d'installations de commutation téléphonique, de mémorisation de données protégées contre les erreurs, comportant une unité de commande de mémoire, dont au moins les parties centrales sont en double et à laquelle sont envoyés tous les signaux arrivants,
caractérisé par le fait
que l'on retransmet par la première (St0) des parties en double de commande de mémoire, outre les signaux d'adresse et de commande (Adr, St), exclusivement les données utiles proprement dites (Schd) et par la seconde des parties en double de commande de mémoire (St1), outre les signaux d'adresse et de commande mentionnés, exclusivement les données de contrôle (Kd) qui sont associés aux données utiles en liaison avec la protection des données, et on enregistre les données utiles et les données de contrôle chacune à la même adresse dans des mémoires distinctes, fonctionnant d'une manière sychrone du point de vue cadence, de données utiles (SPN) et de données de contrôle (SPK), les données utiles et les données de contrôle étant soumises à partir de ces mémoires en commun au contrôle des données, lors de la lecture.

2. Procédé suivant la revendication 1, caractérisé par le fait que l'on compare les données de contrôle (KD), qui doivent être enregistrées à partir de la seconde partie (ST1) de commande de la mémoire dans la mémoire particulière considérée (SPK), pour leur délivrance, à des données de contrôle correspondantes, qui sont disponibles dans la première partie (St0) de commande de la mémoire.

3. Procédé suivant la revendication 2, caractérisé par le fait que ladite comparaison est une comparaison de parité.
